# EUROPEAN PATENT APPLICATION

(11) **EP 4 621 808 A1**
(43) Date of publication of application: **24.09.2025**
(21) Application number: 24382301.0
(22) Date of filing: 20.03.2024
(51) Int. Cl.: H01B 1/24, H10K 30/50, H10K 71/15, H10K 85/50

(54) **CARBON PASTE COMPOSITION AND A METHOD OF PRODUCING THE SAME**

(71) Applicant: Fundació Institut Català de Nanociència i Nanotecnologia (ICN2), 08193 Bellaterra (ES); Consejo Superior de Investigaciones Científicas (CSIC), 28006 Madrid (ES)
(72) Inventor: Lira-Cantú, Mónica, 08757 Corbera de Llobregat (Barcelona) (ES); Zambrzycki, Marcel, 08193 Cerdanyola del Vallès (Barcelona) (ES); Karimipour, Masoud, 08290 Cerdanyola del Vallès (Barcelona) (ES)
(74) Representative: Clarke, Modet y Cía., S.L.

(57) **Abstract**

The present application relates to a carbon paste composition and a method of producing the same. The carbon paste composition comprises polyvinylcarbazole (PVK) and a tailored mixture of solvents. The PVK is used as a semiconducting binder replacing the conventionally used poly(vinyl acetate) found in commercial carbon-based pastes. This carbon paste composition is suitable for use in the preparation of perovskite solar cells or other types of organic electronics. This application also discloses a method to deposit the carbon paste composition in a perovskite solar cell.

## Description

### Technical field

This application relates to a carbon paste composition suitable for use in perovskite solar cells, or other types of organic electronics, and a method of producing the same.

### Background art

In the pursuit of sustainable and efficient energy sources, solar energy has emerged as a frontrunner, with perovskite solar cells standing out as a promising technology on the horizon. These cells, named after their crystal structure reminiscent of the mineral perovskite, have demonstrated remarkable photovoltaic performance, rivalling traditional silicon-based solar cells. However, to harness the full potential of perovskite solar cells and accelerate their integration into mainstream energy solutions, researchers and manufacturers are exploring innovative methods for fabrication and commercialization. One such method that has garnered significant attention is the application of carbon paste in the manufacturing process of perovskite solar cells.

Carbon paste offers unique advantages, such as enhanced electrical conductivity, improved stability, and costeffectiveness, making it a key player in advancing perovskite solar cell technology towards widespread adoption.

Carbon paste plays a pivotal role in perovskite solar cell construction, particularly as a critical component in charge extraction and electron transport layers. However, its application presents several significant challenges that need to be overcome to ensure the optimal performance and durability of these solar cells.

While it offers several advantages, such as low-cost fabrication and good electrical conductivity, it also presents several main issues and challenges:

### A) Stability and Degradation:

Carbon paste can be prone to degradation over time due to exposure to moisture, oxygen, and UV radiation. This degradation can lead to a decrease in performance and a shorter lifespan of perovskite solar cells.

### B) Contact Resistance:

The quality of the carbon paste interface with the perovskite layer can affect the contact resistance, leading to energy losses and reduced efficiency. High contact resistance can hinder the efficient extraction of electrons generated in the perovskite layer.

### C) Compatibility with Perovskite Materials:

Ensuring good compatibility between the carbon paste and perovskite materials is essential. Some carbon pastes may chemically interact with perovskite layers, causing deterioration or instability.

### D) Uniformity and Thickness:

Achieving uniform and precise application of carbon paste across the solar cell's surface can be challenging. Inconsistent thickness or distribution can result in localized performance variations and reduced overall efficiency.

### E) Scalability:

The scalability of the carbon paste application process can be a concern when transitioning from laboratory-scale research to large-scale manufacturing. Developing costeffective and efficient methods for applying carbon paste in mass production is a significant challenge.

### F) Environmental Impact:

Carbon paste typically contains carbon black and other materials, and the environmental impact of its production and disposal must be considered. Sustainable and ecofriendly alternatives are being explored to address these concerns.

To address these issues, ongoing research and development efforts are focused on improving the stability and durability of carbon paste, optimizing its application techniques, developing more environmentally friendly formulations, and enhancing its compatibility with various perovskite materials. These efforts aim to unlock the full potential of perovskite solar cells by mitigating the challenges associated with carbon paste as a contact material.

Keeping the temperature low during processing allows to not disturb the structure of metal halide perovskite layer, which can improve long-term stability of cells. Furthermore, the solvents mixture has been selected to be inert with respect to metal halide perovskites, thus it can be safely applied directly onto it.

The following paragraph discloses a list of patents within the same technical field of the present invention.

CN104966548 discloses a perovskite solar cell conductive carbon paste which comprises organic solvents, binders and conductive filling materials. The conductive carbon paste further comprises inorganic additives ZrO₂ or NiO powder. The invention further discloses a carbon counter electrode for a perovskite solar cell. The carbon counter electrode is prepared and acquired by adopting the above-mentioned conductive carbon paste in a screen-printing means. A method of preparing the conductive carbon paste is further disclosed. The conductive carbon paste which does not make a perovskite film corroded further increases the photoelectric conversion efficiency.

CN109585054 discloses a process for preparing a conductive carbon paste by employing a green solvent substitution method which is applied to a perovskite solar cell. The perovskite solar cell structure comprises a substrate, a transparent electrode, a dense layer, a porous layer, a perovskite light absorption layer and a carbon counter electrode which are stacked in order, the manufacturing material of the carbon counter electrode is mainly dried conductive carbon paste replaced with an organic solvent, and the perovskite light absorption layer is formed by the photovoltaic materials with perovskite structures. The process for preparing conductive carbon paste is suitable for perovskite solar energy counter electrodes with various structures.

CN111312429 relates to the preparation method of a carbon nanotube conductive paste for solar cells. The dispersion effect of the carbon nanotube conductive paste is improved, the carbon nanotube conductive pastes are easy to separate out and layer, and the use requirement of a solar cell is met.

KR20130014792 discloses a carbon nanotube/metal composite paste composition is provided to provide a carbon nanotubes/metal composite electrode as a dye-sensitized solar cell, thereby improving the efficiency of a solar cell. A manufacturing method of a carbon nanotube/metal composite electrode comprises is also disclosed.

KR20130046978 discloses a manufacturing method of electrode paste is provided to improve absorption of dyes by forming macropores with a sufficient surface area and to maximize the photo conversion efficiency.

JP5528871 discloses a method for preparing a carbon paste for screen printing of a counter electrode of a dye-sensitized solar cell, the carbon paste being capable of preparing a carbon counter electrode on Fluorine-doped Tin Oxide glass by screen printing, forming uniform particles, and reducing the film thickness dependency of the counter electrode.

KR100928219 discloses a carbon nanotube paste composition, a carbon nanotube electrode formed by using the composition, a method for preparing the electrode, and a dye sensitive solar cell containing the electrode are provided to improve electrical conductivity and the adhesive strength to a substrate.

US2012000523 discloses a metal paste composition for forming an electrode, and a silver-carbon composite electrode and a silicon solar cell using the same. An electrode formed using the metal paste composition does not have a substantial deterioration in its electrical characteristics although the silver content is reduced.

KR101068940 discloses a carbon nanotube/metal composite paste composition for a counter electrode of a dye-sensitized solar cell, and a carbon nanotube / metal complex counter electrode using thereof are provided to secure the high oxidation-reduction catalyst speed. A carbon nanotube / metal complex counter electrode includes an optical electrode with a photo-sensitized dye layer, a counter electrode formed by spreading the composition to a substrate, and an electrolyte.

KR101156122 discloses a metal paste composition for forming an electrode, a silver-carbon composite electrode using thereof, and a silicon solar cell are provided to reduce the amount of silver used for manufacturing the electrode without reducing the capacity of the electrode. A silicon solar cell includes a silicon semiconductor substrate, an emitter layer formed on the substrate, an anti-reflective layer formed on the emitter layer, a front electrode connected to the emitter layer by penetrating the anti-reflective layer, and a rear electrode connected to the rear side of the substrate.

### Summary

The present invention relates to a carbon paste composition comprising:
Synthetic graphite between 22.5 and 37.5 wt%;
Carbon black between 7.5 and 12.5 wt%;
Polyvinylcarbazole between 2.5 and 7.5 wt%;
Ethylcellulose between 0.5 and 3.5 wt%;
ZrO₂ between 0.05 and 0.75 wt%;
Methyl benzoate between 10 and 40 wt%;
Chlorobenzene between 10 and 40 wt%.

In one embodiment, the synthetic graphite comprises particles with an average diameter between 10-50 um.

In one embodiment, carbon black has an average particle size between 5 and 500 nm.

In one embodiment, ZrO₂ has an average particle size between 5 and 500 nm.

In one embodiment, it comprises 32.5 wt% synthetic graphite, 9 wt% carbon black, 5.5 wt% Polyvinylcarbazole, 2.5 wt% Ethylcellulose, 0.5 wt% ZrO₂, 25% Methyl benzoate, 25% Chlorobenzene.

The invention also relates to a method to produce the carbon paste composition comprising the following steps:
- Mixing together polyvinylcarbazole in a concentration between 2.5 and 7.5 wt%, ethylcellulose in a concentration between 0.5 and 3.5 wt%, ZrO2 in a concentration between 0.05 and 0.75 wt%, methyl benzoate in a concentration between 10 and 40 wt% and chlorobenzene in a concentration between 10 and 40 wt%;
- Stirring the mixture for a time between 10 to 30 hours at a temperature between 25 to 55 °C;
- Adding carbon black to the previous mixture in a concentration between 7.5 and 12.5 wt% and mixing it;
- Subjecting the mixture to ultrasonic homogenization;
- Adding synthetic graphite to the previous mixture in a concentration between 22.5 and 37.5 wt% and mixing it;
- Stirring the previous mixture in a sealed container for a time between 5 to 24 h to obtain the carbon paste composition.

In one embodiment, carbon black is annealed before being added into the composition.

In one embodiment, the ultrasonic conditions are 15% of power of a sonicator processor for a time between 1 to 5 min.

It is also disclosed a method to deposit the carbon paste composition in a perovskite solar cell comprising the following steps:
- Sticking masking tape to the edges of the cell;
- Placing the carbon paste composition paste on the taped upper-edge of the cell;
- Spreading the carbon paste composition paste on the unmasked area of the cell;
- Allowing the solvent of the carbon paste composition to evaporate and waiting at least 30 minutes before performing the next step;
- Annealing the cell at least once at a temperature between 50 and 100 °C for a time between 10 and 60 min.

In one embodiment, the first annealing step is performed at a temperature of less than 60°C.

In one embodiment, the carbon paste composition is for use in the preparation of a perovskite solar cell, optoelectronic devices, printed electronics or other types of organic electronics.

### General description

The present invention relates to a unique composition of carbon paste comprising polyvinylcarbazole (PVK) and a tailored mixture of solvents. The PVK is used as a semiconducting binder replacing the conventionally used poly(vinyl acetate) (PVAc) found in commercial carbon-based pastes.

Carbon perovskite solar cells (C-PSCs), using carbon-based counter electrodes (C-CEs), promise to mitigate instability issues and replace costly metals such as gold (Au), silver (Ag) or Copper (Cu) electrodes, while providing solution processed and low-cost device configurations. Thus, the present invention relates to a carbon-additive composition dispersed in organic solvent and comprising an organic binder, and an application thereof as described below.

The PVK enhances the energy alignment between C-CEs and hole transport layer (HTL) and increases the electrical conductivity of the resultant electrode. The mixture of organic solvents, chlorobenzene/methyl benzoate enables curing of the paste at a temperature below 120°C, and as low as 60°C, and does not cause formation of pores in the electrode layer.

The analysis of prior art patents in this technical field, confirm the uniqueness of the present invention, and the main difference from the existing patents is the use of the semiconducting polymer polyvinylcarbazole as the main binder of the carbon paste. Its use ensures high conductivity and the appropriate energy alignment with the perovskite active layer in the solar cell, or when used in or other types of organic electronics. Another innovation is the use of a special mixture of solvents, which doesn't degrade the perovskite layer, maintaining low porosity of the electrode layer, and allowing to reduce the temperature of the annealing step to as low as 60 °C.

### Brief description of drawings

For easier understanding of this application, figures are attached in the annex that represent the preferred forms of implementation which nevertheless are not intended to limit the technique disclosed herein.
Figure 1 shows the Raman spectra of carbon black annealed in various temperatures.
Figure 2 shows XRD patterns of carbon black annealed in various temperatures.
Figure 3 shows XPS spectra of carbon electrodes: a) survey spectra, b) C1s core level, c) O1s core level, d) sp2 carbon content depending on temperature of treatment of carbon black.
Figure 4 shows the results of water contact angle measurements on carbon electrodes containing various types of carbon black.
Figure 5 shows electrical conductivity of carbon electrodes.
Figure 6 shows the work function of carbon electrodes.
Figure 7 shows SEM images of surface of test carbon electrodes.
Figure 8 shows the device configuration (left) and band structure (right) of PVK and PVAc. PVK is more adventageous for the application as a binder for the carbon paste as compared to commonly used PVAc.
Figure 9 shows the PCE of different types of c-PSC devices, and Close-up showing the effects of interface modification with different substances.
Figure 10a shows power conversion efficiency of the c-PSC devices after 1600 h. Tests in accordance with ISOS-D1 protocol. The close-up disclosed on Figure 10b shows the effect of interface modification on stability of the cells.
Figure 11 shows outdoor MPP tracking of the devices fabricated with different carbon pastes based on ISOS-O protocol of stability study of perovskite solar cells. Cell 11: Commercial carbon paste, Cell 12: PVAc based carbon paste, Cell 13-16: all made by novel PVK based carbon pastes; three different time scales are presented: Figure 11a: all range, Figure 11b: from 1000 h to 1350 h and Figure 11c: 1335 h to 1350 h.

### Detailed description of embodiments

Now, preferred embodiments of the present application will be described in detail with reference to the annexed drawings. However, they are not intended to limit the scope of this application.

The present invention relates to carbon paste composition comprising polyvinylcarbazole and a mixture of solvents, among other compounds.

The carbon paste composition can be used to produce thin films as conductive electrodes for electronics, particularly in devices such as perovskite solar cells, optoelectronic devices, printed electronics or other types of organic electronics. This paste also allows the fabrication of such devices at room temperature (20-25°C) or the use of temperature-sensitive materials such as metal halide perovskites.

The carbon paste composition can be deposited by solution processing methods such as screen printing, doctor blading, or spin coating, with subsequent annealing of the deposited layer.

The carbon paste composition comprises the following compounds:
Synthetic graphite between 22.5 and 37.5 wt%;
Carbon black between 7.5 and 12.5 wt%;
Polyvinylcarbazole (PVK) between 2.5 and 7.5 wt%;
Ethylcellulose (ETC) between 0.5 and 3.5 wt%;
ZrO₂ between 0.05 and 0.75 wt%;
Methyl benzoate between 10 and 40 wt%;
Chlorobenzene between 10 and 40 wt%.

In one embodiment, the Carbon black has an average particle size between 5 and 500 nm.

In one embodiment, ZrO₂ has an average particle size between 5 and 500 nm.

In one embodiment, the synthetic graphite comprises particles with an average diameter between 10-50 um.

In one particular embodiment, the carbon paste composition comprises 32.5 wt% Synthetic graphite, 9 wt% carbon black, 5.5 wt% Polyvinylcarbazole (PVK), 2.5 wt% Ethylcellulose (ETC), 0.5 wt% ZrO₂, 25% Methyl benzoate, 25% Chlorobenzene.

The method to produce the carbon paste composition comprises the following steps:
- Mixing together polyvinylcarbazole in a concentration between 2.5 and 7.5 wt%, ethylcellulose in a concentration between 0.5 and 3.5 wt%, ZrO₂ in a concentration between 0.05 and 0.75 wt%, methyl benzoate in a concentration between 10 and 40 wt% and chlorobenzene in a concentration between 10 and 40 wt%;
- Stirring the mixture for a time between 10 to 30 hours at a temperature between 25 to 55 °C;
- Adding carbon black to the previous mixture in a concentration between 7.5 and 12.5 wt% and mixing it;
- Subjecting the mixture to ultrasonic homogenization;
- Adding synthetic graphite to the previous mixture in a concentration between 22.5 and 37.5 wt% and mixing it;
- Stirring the previous mixture in a sealed container for a time between 5 to 24 h to obtain the carbon paste composition.

In one embodiment, carbon black has an average particle size between 5 and 500 nm.

In one embodiment, ZrO₂ has an average particle size between 5 and 500 nm.

In one embodiment, carbon black is annealed before being added into the composition.

In one embodiment, the ultrasonic conditions are 15% of maximum power of a sonicator processor for a time between 1 to 5 min.

In one embodiment, a method to deposit the carbon paste composition in a perovskite solar cell comprises the following steps:
- Sticking masking tape to the edges of the cell;
- Placing the carbon paste composition on the taped upper-edge of the cell;
- Spreading the carbon paste composition on the unmasked area of the cell;
- Allowing the solvent of the carbon paste composition to evaporate and waiting at least 30 minutes before performing the next step;
- Annealing the cell at least once at a temperature between 50 and 100 °C for a time between 10 and 60 min.

In one embodiment, a silver paste/copper tape contact can be added directly on the surface of the carbon electrode, which is the layer of carbon paste composition, of the cell.

It is important to not anneal the cell right away after the deposition of the carbon paste composition. At least 30 min should pass between the evaporation of the solvent and the annealing step.

Regardless of the fabrication procedure applied by the enduser, the temperature of the first annealing step is performed at a temperature of less than 60°C.

In one embodiment, the disclosed method comprises more than one annealing step. There can be as many annealing steps as required by the specific fabrication procedure chosen by the user, wherein the first step shall not be higher than 60 °C.

The previously described method is a non-limiting method to deposit the carbon paste composition of the present invention in a perovskite solar cell. Other deposition methods can be implemented using the carbon paste composition to produce a perovskite solar cell.

### Examples

### Characterization of carbon black and polyvinylcarbazole (PVK) used in the fabrication of the carbon paste composition:

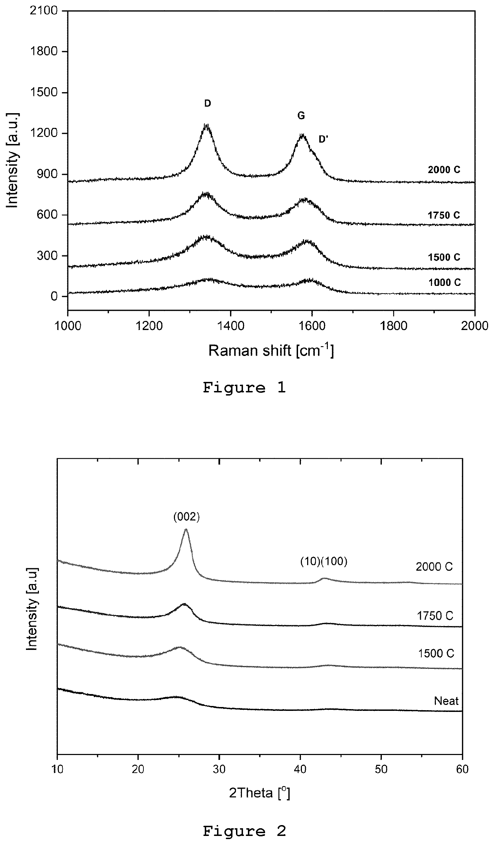

Fig. 1 depicts the Raman peak of Carbon black (CB) annealed in different temperatures. As it is clear from the definition of D and G bands, where D band represents the defects bonding and G corresponds to stretching vibrations of carbon-carbon graphitic bonds, with the increase of temperature and consequently, increase of G to D ratio, the defect concentration decreases that has a significant effect on the conductivity and work function of CB used in the paste composition preparation.

Fig. 2 shows the XRD of CB with different annealing temperatures in harmony with the Raman analysis, it also shows that with the increase of annealing temperature, the crystallinity increases and the interplanar distance also decreases as it was also confirmed by the increase of G to D band ratio in Fig. 1.

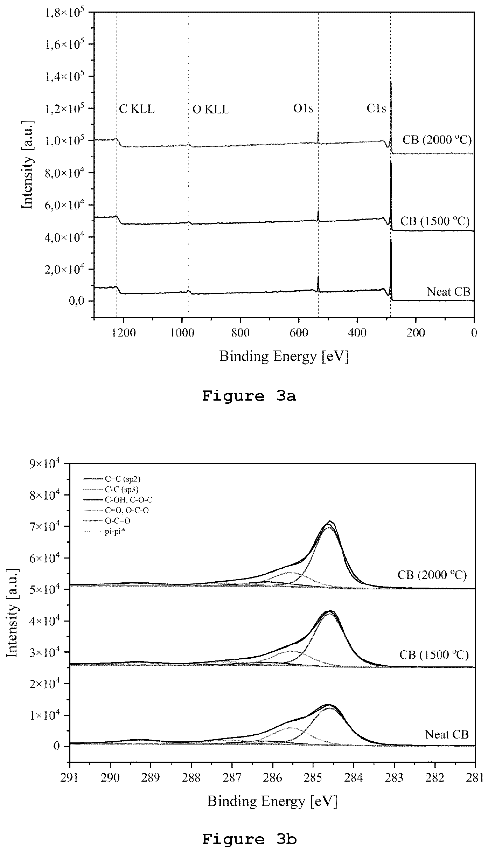

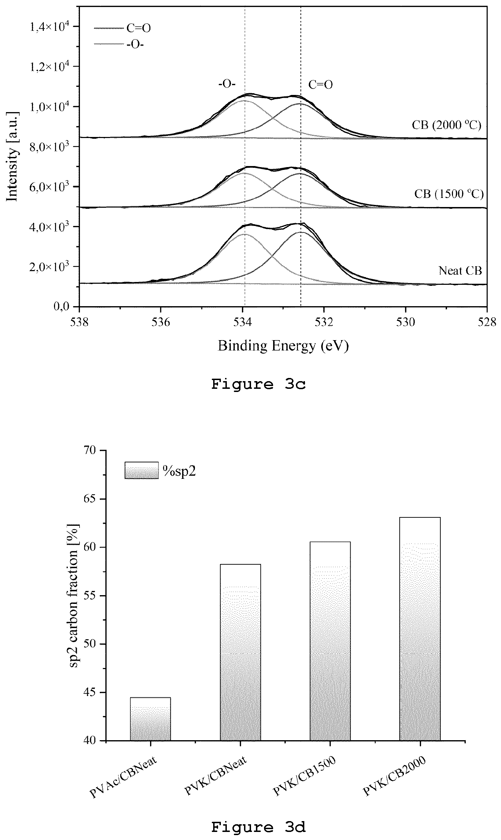

To study the effect of the addition of PVK instead of PVAc to annealed CB for the paste composition preparation, which is one of the main novelties of this invention, a detailed XPS analysis was performed as shown in Fig. 3 and Table 1, with CBNeat being CB not annealed, CB1500 being CB annealed at 1500 and CB200 being CB annealed at 2000°C. C 1s peak deconvolution and O 1s deconvolution apparently show the clear reduction of C=O bonds, with addition of PVK instead of PVAc. The statistical comparison of sp2 bonding shows clearly the fact that the carbon paste composition with PVK has the highest values and the CB annealed at 1500 and 2000°C show the highest sp2 configuration for the carbon paste structure.

**Table 1. XPS results of the carbon paste composition**

| Samp le | Survey scan | | | C1s core level | | | | | | | O1s core level | | N1s cor e lev el |
|---|---|---|---|---|---|---|---|---|---|---|---|---|---|
| | C 1s | O 1s | N 1s | C= C (s p2 ) | C-C (s p3 ) | C-OH , CO-C, C-N | C= O, O-CO | O-C= O | pi - pi * | %s p2 | C= O | - O- | Pyr rol ic N |
| Energy [eV] | 28 5. 0 | 53 3. 2 | 40 0. 2 | 28 4. 60 | 28 5. 45 | 28 6. 50 | 28 7. 30 | 28 9. 30 | 29 1. 00 | - | 53 2. 70 | 53 3. 30 | 400 .20 |
| PVAc /CBN eat | 86 ,2 7 | 13 ,7 3 | 0, 00 | 43 ,8 7 | 6, 54 | 24 ,0 2 | 20 ,6 8 | 4, 32 | 0, 58 | 44 ,4 5 | 47 ,3 1 | 52 ,6 9 | 0,0 0 |
| PVK/ CBNe at | 90 ,5 1 | 7, 97 | 1, 52 | 55 ,4 0 | 14 ,7 3 | 21 ,4 9 | 4, 38 | 1, 12 | 2, 87 | 58 ,2 7 | 33 ,7 1 | 66 ,2 9 | 100 ,00 |
| PVK/ CB15 00 | 92 ,1 6 | 6, 51 | 1, 33 | 57 ,2 5 | 14 ,9 1 | 19 ,6 8 | 4, 01 | 0, 85 | 3, 29 | 60 ,5 4 | 24 ,2 4 | 75 ,7 6 | 100 ,00 |
| PVK/ CB20 00 | 92 ,9 6 | 5, 91 | 1, 14 | 59 ,4 9 | 13 ,6 9 | 17 ,0 4 | 5, 04 | 1, 14 | 3, 60 | 63 ,0 9 | 19 ,6 1 | 80 ,3 9 | 100 ,00 |

Thus, both of described procedures - replacement of PVAc with PVK and heat treatment (i.e., annealing) of carbon black, results in an increase in delocalized sp2 bonds, which enhances the electronic transport properties of the carbon paste composition.

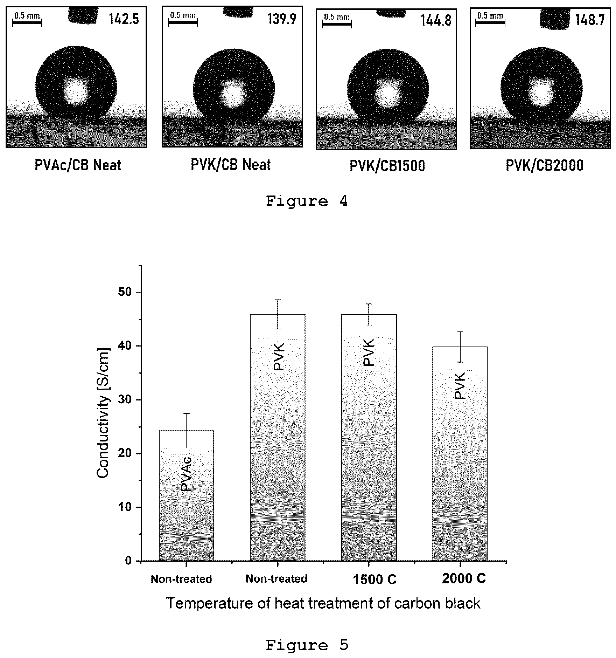

To address another issue, which is environmental impact and compatibility with perovskite, contact angle measurements were performed, which are shown in Fig. 4. Apparently, CB annealed at 1500°C and 2000°C with PVK show induced hydrophobicity that favors best its deposition on a perovskite layer.

The most important characterization was conductivity measurements of a thin film fabricated with the prepared carbon paste composition. Fig. 5 shows the electrical conductivity of the prepared paste with PVK. The pastes prepared with PVK have almost 2-fold conductivity compared to the commercial PVAc used in commercial pastes. The CB without annealing and annealed at 1500°C show the highest conductivity among all.

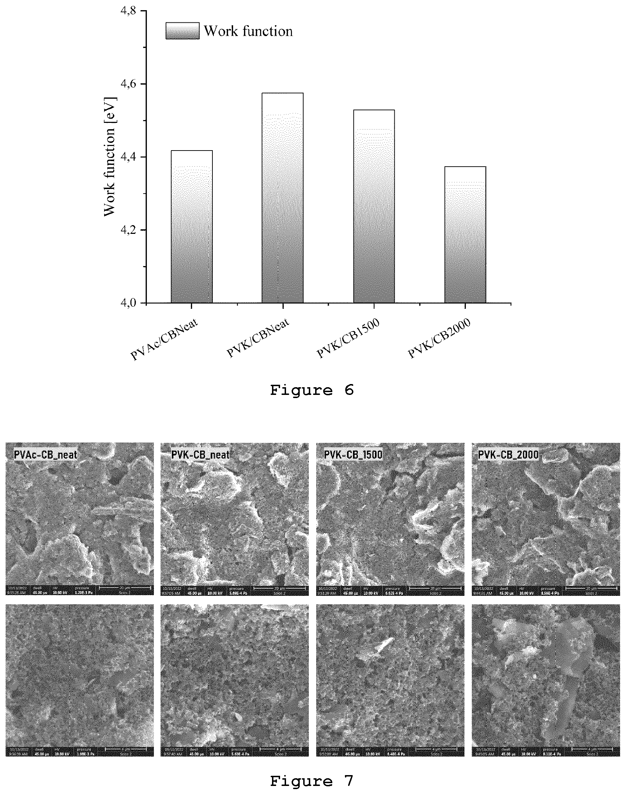

Another crucial issue is the work function (WF) value that should be considered in using the carbon paste composition in device fabrication. Fig. 6 shows the WF values obtained from UPS measurements. In excellent agreement with electrical conductivity, WF is increased for the PVK-based carbon paste composition for non-treated (neat) and 1500°C annealed CB. In addition to macroscopic properties, the morphology of CB paste composition comprising the PVK polymer also influences the overall functionality, adherence to sublayers, roughness and functionality of the paste layer for charge transfer and extraction. Fig. 7 shows SEM images of different paste compositions, among them the carbon paste composition comprising PVK and CB non-treated (neat) and annealed at 1500°C, which show very similar morphology to that of standard PVAc-based paste.

Thus, it can be concluded that addition of PVK as polymer binder to the CB (non-treated and annealed at 1500°C) yields higher conductivity, higher WF, better degree of crystallinity and lower defect states and highest sp2 configuration of carbons.

### Perovskite solar cell device fabrication and measurements

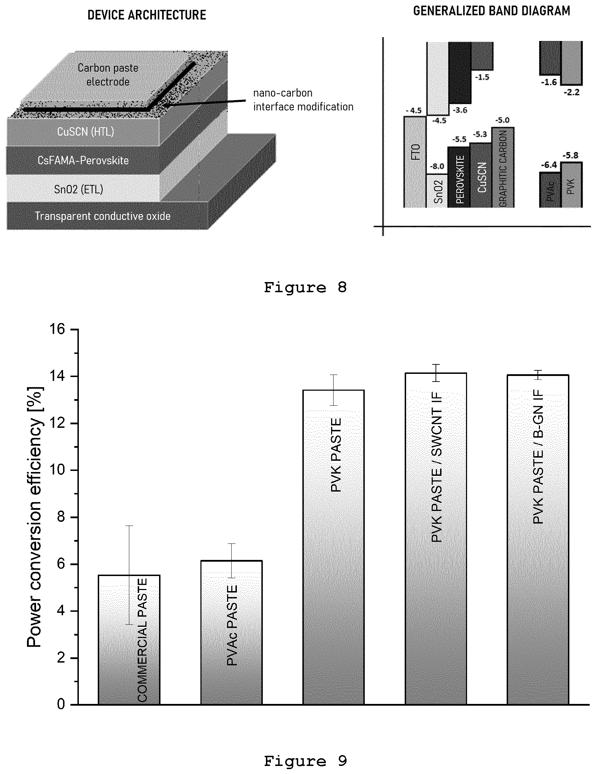

Fig. 8 depicts a device configuration and the application of the carbon paste composition in a normal configuration on top of a CuSCN layer (HTL layer). The corresponding band diagram obtained from the WF values show that PVK-based carbon paste composition serves as better material for charge extraction compared to PVAc-based paste.

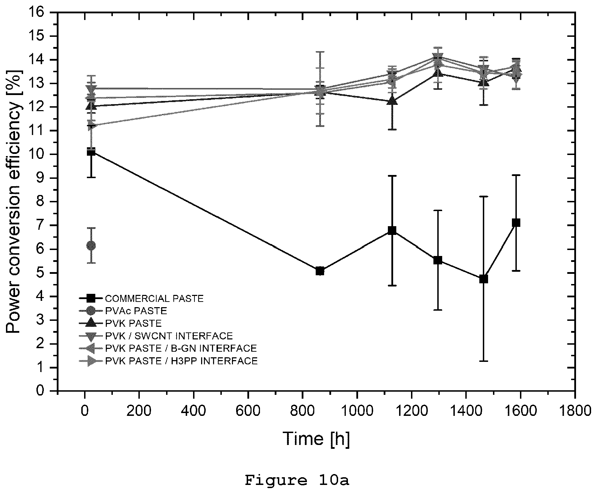

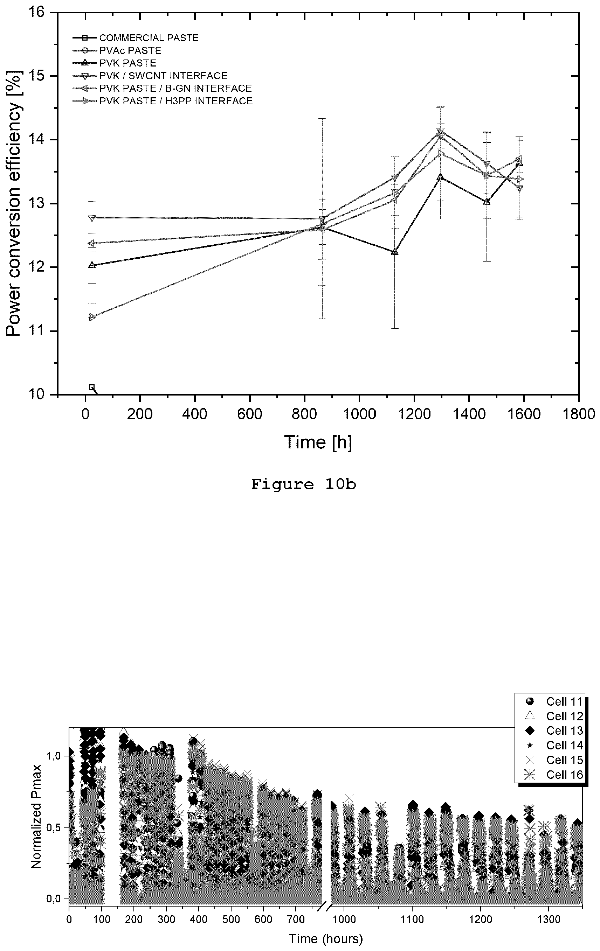

The significant enhancement of power conversion efficiency (PCE) of the devices is shown in Fig. 9, where the corresponding devices with a commercial paste, as well as an equivalent paste with PVAc, have been fabricated and measured. PVK apparently enhances the PCE of the devices in all cases with or without interface modification. More importantly, to emphasize the compatibility of the new PVK-based carbon paste compositions with perovskite, the PCE of the devices was measured in a regular basis according to ISOS-D protocol and the results in Fig. 10 show apparent improvement of PCE of the devices with PVK in the carbon paste composition, while the device with the commercial paste degraded as well as in PVAc paste case.

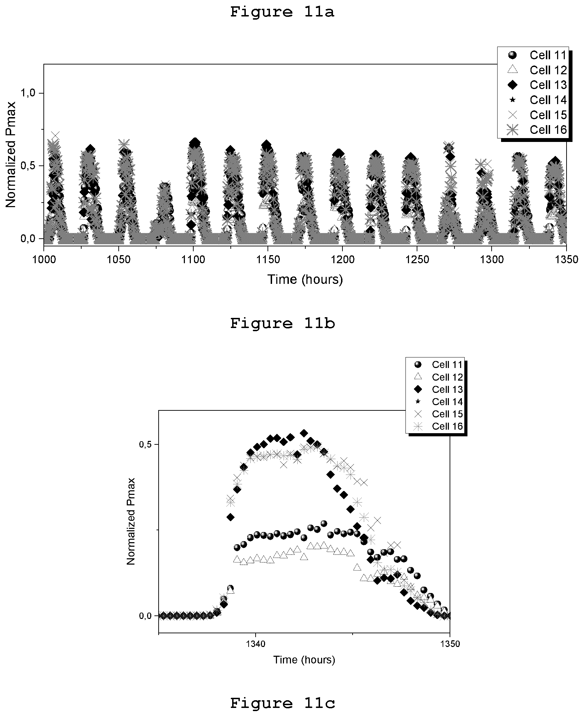

To more robustly indicate the operational and environmental stability of the carbon paste composition of the present invention, the devices were encapsulated and subjected to aggressive outdoor real condition measurements according to the protocol ISOS-O-1. The recorded maximum power point (MPP) for more than 1400 h has been plotted in Fig. 11. It clearly indicates the superior stability of the devices fabricated with the carbon paste composition of the present invention, which retain more than 50% of their initial MPP while the devices with commercial paste (cell 11) and PVAc paste (Cell 12) degraded significantly more than 75%.

This description is of course not in any way restricted to the forms of implementation presented herein and any person with an average knowledge of the area can provide many possibilities for modification thereof without departing from the general idea as defined by the claims. The preferred forms of implementation described above can obviously be combined with each other. The following claims further define the preferred forms of implementation.

## Claims

1. A carbon paste composition comprising:
Synthetic graphite between 22.5 and 37.5 wt%;
Carbon black between 7.5 and 12.5 wt%;
Polyvinylcarbazole between 2.5 and 7.5 wt%;
Ethylcellulose between 0.5 and 3.5 wt%;
ZrO₂ between 0.05 and 0.75 wt%;
Methyl benzoate between 10 and 40 wt%;
Chlorobenzene between 10 and 40 wt%.

2. Carbon paste composition according to the previous claim, wherein the synthetic graphite comprises particles with an average diameter between 10-50 um.

3. Carbon paste composition according to any of the previous claims, wherein carbon black has an average particle size between 5 and 500 nm.

4. Carbon paste composition according to any of the previous claims, wherein ZrO₂ has an average particle size between 5 and 500 nm.

5. The composition according to any of the previous claims, wherein it comprises 32.5 wt% synthetic graphite, 9 wt% carbon black, 5.5 wt% Polyvinylcarbazole, 2.5 wt% Ethylcellulose, 0.5 wt% ZrO₂, 25% Methyl benzoate, 25% Chlorobenzene.

6. A method to produce the carbon paste composition disclosed in any of the previous claims comprising the following steps:
- Mixing together polyvinylcarbazole in a concentration between 2.5 and 7.5 wt%, ethylcellulose in a concentration between 0.5 and 3.5 wt%, ZrO2 in a concentration between 0.05 and 0.75 wt%, methyl benzoate in a concentration between 10 and 40 wt% and chlorobenzene in a concentration between 10 and 40 wt%;
- Stirring the mixture for a time between 10 to 30 hours at a temperature between 25 to 55 °C;
- Adding carbon black to the previous mixture in a concentration between 7.5 and 12.5 wt% and mixing it;
- Subjecting the mixture to ultrasonic homogenization;
- Adding synthetic graphite to the previous mixture in a concentration between 22.5 and 37.5 wt% and mixing it;
- Stirring the previous mixture in a sealed container for a time between 5 to 24 h to obtain the carbon paste composition.

7. The method according to the previous claim, wherein carbon black is annealed before being added into the composition.

8. The method according to any of the claims 6 to 7, wherein the ultrasonic conditions are 15% of power of a sonicator processor for a time between 1 to 5 min.

9. A method to deposit the carbon paste composition described in any of the claims 1 to 5, in a perovskite solar cell comprising the following steps:
- Sticking masking tape to the edges of the cell;
- Placing the carbon paste composition paste on the taped upper-edge of the cell;
- Spreading the carbon paste composition paste on the unmasked area of the cell;
- Allowing the solvent of the carbon paste composition to evaporate and waiting at least 30 minutes before performing the next step;
- Annealing the cell at least once at a temperature between 50 and 100 °C for a time between 10 and 60 min.

10. The method to deposit the carbon paste composition according to the previous claim, wherein the first annealing step is performed at a temperature of less than 60°C.

11. Use of the carbon paste composition disclosed in any of the claims 1 to 5, in the preparation of a perovskite solar cell, optoelectronic devices, printed electronics or other types of organic electronics.
